# EUROPÄISCHE PATENTSCHRIFT

(11) **EP 3 150 033 B1**
(45) Veröffentlichungstag und Bekanntmachung des Hinweises auf die Patenterteilung: **23.06.2021**
(21) Anmeldenummer: 15711800.1
(22) Anmeldetag: 25.03.2015
(51) Int. Cl.: H05K 3/32, H05K 1/18

(54) **VERFAHREN ZUM HERSTELLEN EINER KONTAKTIERUNG MIT EINER FLEXIBLEN LEITERPLATTE**
METHOD OF MAKING CONTACT WITH A FLEXIBLE PRINTED CIRCUIT BOARD
MÉTHODE DE MISE EN CONTACT AVEC UNE CARTE DE CIRCUIT IMPRIMÉ SOUPLE

(30) Priorität: 28.05.2014 DE 102014210255
(43) Veröffentlichungstag der Anmeldung: 05.04.2017
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2015/056458
(87) Internationale Veröffentlichungsnummer: WO 2015/180862

(56) Entgegenhaltungen:
- EP-A1- 1 305 988
- WO-A1-00/49841
- DE-A1-102009 002 954
- DE-A1-102009 026 460
- DE-A1-102010 039 146
- US-A- 4 647 133
- US-A1- 2007 193 773
- US-A1- 2011 036 627

## Beschreibung

### Gebiet der Erfindung

Die Erfindung betrifft ein Verfahren zum Herstellen einer Kontaktierung mit einer flexiblen Leiterplatte.

### Hintergrund der Erfindung

Bei einem Automatikgetriebe in einem Fahrzeug wird das Steuermodul direkt an den mechanischen Komponenten des Fahrzeugs angebracht. Dazu können elektrische Kontakte des Steuermoduls mit entsprechenden elektrischen Kontakten der mechanischen Komponenten (wie etwa Ventile) zusammengeschweißt werden. Als Basis des Steuermoduls kann beispielsweise eine Flexfolie bzw. flexible Leiterplatte, eine starre Leiterplatte oder ein Stanzgitter verwendet werden.

Flexible Leiterplatten umfassen in etwa zwei Folien, zwischen denen eine flexible Leiterschicht angeordnet ist. Wird eine flexible Leiterplatte als Kontaktierung an einen Pin, der aus einer Elektronik (beispielsweise einem Steuergerät oder einem Sensor) herausragt, verwendet, kann der Pin in eine Öffnung in einer der beiden Folien gesteckt werden und die Leiterschicht mittels Laserschweißens mit dem Pin verbunden werden. Eine derartig einseitig geöffnete flexible Leiterplatte ist beispielsweise in EP 1 305 988 B1 beschrieben.

Aus der US 4 647 133 A ist ein Verfahren zum Herstellen einer Kontaktierung bekannt, bei der eine flexible Leiterplatte mit einem Kontaktpin verschweißt wird. Die flexible Leiterplatte weist eine Leiterschicht zwischen einer ersten Folie und einer zweiten Folie auf. Im Laufe des Verfahrens wird in die zweite Folie mittels der Schweißelektrode eine zweite Öffnung eingebracht.

Aus der WO 00/49841 A1 ist ein Verfahren zum Herstellen einer Kontaktierung bekannt, bei dem eine flexible Leiterplatte mit einem Kontaktpin verschweißt wird. Die flexible Leiterplatte weist eine erste Folie mit einer ersten Öffnung und eine zweite Folie mit einer als Beleuchtungsöffnung vorgesehenen zweiten Öffnung 5 sowie eine Leiterschicht zwischen der ersten Folie und der zweiten Folie auf.

Da der Laserstrahl zur Verschmelzung von Pin und Leiterschicht durch eine Deckfolie hindurchstrahlt, kann der Kleber, der die Folie mit der Leiterschicht verklebt, und auch das Basismaterial der Folie durch lokale Erwärmung beschädigt werden.

### Zusammenfassung der Erfindung

Mit der Erfindung kann das elektrische Kontaktieren einer flexiblen Leiterplatte an einen Kontaktpin vereinfacht werden. Auch kann mit der Erfindung die Fehleranfälligkeit des Kontaktiervorgangs reduziert werden.

Diese Vorteile können mit dem Gegenstand der unabhängigen Ansprüche erreicht werden. Weitere Ausführungsformen der Erfindung ergeben sich aus den abhängigen Ansprüchen und aus der folgenden Beschreibung.

Eine flexible Leiterplatte wird auch Flexfolie genannt. Eine solche Leiterplatte kann beispielsweise zur Verbindung eines Steuergerätes mit Sensoren und Aktuatoranschlüssen verwendet werden, beispielsweise in einem Getriebesteuergerät.

Die flexible Leiterplatte umfasst eine erste Folie bzw. Basisfolie mit wenigstens einer ersten Öffnung, eine zweite Folie bzw. Deckfolie und eine Leiterschicht zwischen den Folien, wobei durch die erste Öffnung auf die Leiterschicht zugegriffen werden kann. Die beiden Kunststofffolien können beispielsweise aus Polyimid hergestellt sein und/oder mittels eines Klebers mit der Leiterschicht zusammenlaminiert sein. Die Leiterschicht kann eine oder mehrere Leiterbahnen umfassen und/oder kann aus Kupfer, Aluminium oder einem anderen leitenden Material gefertigt sein. Es ist zu verstehen, dass die Folien und die Leiterschicht sehr dünn sein können, um ihre Flexibilität zu gewähren, beispielsweise dünner als 0,1 mm. Die erste Öffnung in der ersten Folie kann als Zugriffsöffnung auf die Leiterschicht aufgefasst werden. Durch die erste Öffnung kann ein Kontaktpin mit der Leiterschicht in Kontakt gebracht werden.

Die zweite Folie weist wenigstens eine zweite Öffnung auf, die der ersten Öffnung zumindest teilweise gegenüberliegt und die einen kleineren Durchmesser als die wenigstens eine erste Öffnung aufweist. Die beiden Öffnungen bzw. Löcher in den Folien liegen einander gegenüber und ermöglichen es, dass auf der dem Kontaktpin gegenüberliegenden Seite ein Schweißvorgang mit Laserlicht kontrollierter ausgeführt werden kann, als wenn die zweite Öffnung nicht vorhanden wäre.

Mit der zweiten Öffnung kann eine Schädigung der flexiblen Leiterplatte durch Überhitzen des Folienklebers (der die flächige Verbindung innerhalb der flexiblen Leiterplatte sicherstellt) und des Basismaterials (wie etwa Polyimid) der Folien vermieden werden, die durch die kurzzeitige Erhitzung der Schweißstelle Gase und Dämpfe entwickeln können, die über die zweite Öffnung abfließen können.

Durch die Wahl eines kleineren Durchmessers für die zweite Öffnung bleibt die Stabilität der flexiblen Leiterplatte erhalten. Größere Bereiche der zweiten Folie bleiben im Bereich der ersten Öffnung über der ersten Folie erhalten.

Dass sich die beiden Öffnungen zumindest teilweise gegenüberliegen, kann bedeuten, dass unter einem Blickwinkel orthogonal zu der Erstdeckungsrichtung der flexiblen Leiterplatte sich die beiden Öffnungen zumindest teilweise überschneiden. Es ist aber auch möglich, dass die erste, größere Öffnung, die zweite, kleinere Öffnung vollständig überdeckt.

Die erste Öffnung kann die zweite Öffnung vollständig überdecken. Mit anderen Worten kann ein großer Bereich der durch die erste Öffnung freigelegten Leiterschicht von der zweiten Folie dort noch unterstützt werden, wo die zweite Öffnung nicht die erste Öffnung überdeckt.

Der Durchmesser der zweiten Öffnung kann weniger als 20% des Durchmessers der ersten Öffnung betragen. Die zweite Öffnung kann wesentlich kleiner als die erste Öffnung sein. Die erste Öffnung kann einen Durchmesser aufweisen, der etwas größer als der Durchmesser des zu kontaktierenden Pins ist, beispielsweise 1 mm bis 1,5 mm. Die zweite Öffnung kann einen wesentlich kleineren Durchmesser aufweisen, beispielsweise 0,1 mm bis 0,4 mm.

Die erste Öffnung und die zweite Öffnung können durch die Leiterschicht vollständig voneinander abgetrennt sein. Die Leiterschicht zwischen den beiden Öffnungen kann vollständig intakt sein. Dies kann beispielsweise dadurch erreicht werden, dass beide Folien vor dem Laminieren auf der Leiterschicht gelocht werden. Ein exaktes Ausrichten der zweiten Folie bezüglich der ersten Folie ist aufgrund des geringeren Durchmessers der zweiten Öffnung dabei nicht notwendig.

Die zweite Öffnung kann sich durch die Leiterschicht bis zur ersten Öffnung erstrecken. Die Leiterschicht zwischen der ersten und der zweiten Öffnung kann auch eine Öffnung aufweisen, über die die beiden Öffnungen in den Folien miteinander in Verbindung stehen. Dies kann beispielsweise durch Lochen der zweiten Folie nach dem Laminieren erreicht werden. Eine exakte Ausrichtung des Stanzwerkzeugs bezüglich der ersten Öffnung ist aufgrund des geringeren Durchmessers der zweiten Öffnung dabei nicht notwendig.

Die Erfindung betrifft ein Verfahren zum Herstellen einer Kontaktierung mit einer flexiblen Leiterplatte, das Verfahren umfasst die Schritte:
- Bereitstellen einer flexiblen Leiterplatte, umfassend: eine erste Folie mit wenigstens einer ersten Öffnung; eine zweite Folie; eine Leiterschicht zwischen der ersten Folie und der zweiten Folie, wobei durch die erste Öffnung auf die Leiterschicht zugegriffen werden kann; wobei die zweite Folie wenigstens eine zweite Öffnung aufweist, die der wenigstens einen ersten Öffnung zumindest teilweise gegenüberliegt und die einen kleineren Durchmesser als die wenigstens eine erste Öffnung aufweist.
- Positionieren der flexiblen Leiterplatte mit der wenigstens einen ersten Öffnung auf wenigstens einem Kontaktpin, so dass die Leiterschicht den wenigstens einen Kontaktpin berührt;
- Anschweißen der Leiterschicht an den Kontaktpin durch die zweite Folie und die zweite Öffnung hindurch, so dass beim Schweißen entstehende Dämpfe und/oder Wärme durch die zweite Öffnung entweichen können.

Die wenigstens eine erste Öffnung kann der wenigstens einen zweiten Öffnung zumindest teilweise gegenüberliegen. Es ist zu verstehen, dass in der Regel nicht eine, sondern eine Mehrzahl von Öffnungen in beiden Folien vorhanden sind.

Die erste Folie kann auf die Leiterschicht laminiert sein, nachdem die erste Öffnung in der ersten Folie erzeugt wurde. Beispielsweise kann die erste Folie als Basisfolie mit Ausstanzungen (d.h. Öffnungen, Löcher) zur späteren Kontaktierung an Pins versehen werden. Anschließend können die Leiterschicht (wie etwa eine Kupferfolie) und anschließend die zweite Folie als Deckfolie auflaminiert werden.

Die zweite Folie kann auf die Leiterschicht laminiert werden, nachdem die zweite Öffnung in der zweiten Folie erzeugt wurde. Beispielsweise können in die zweite Folie Öffnungen mit wesentlich kleinerem Durchmesser gestanzt werden, so dass eine exakte Positionierung der zweiten Folie bezüglich der ersten Folie nicht notwendig ist.

Die zweite Öffnung kann in der zweiten Folie erzeugt werden, nachdem die zweite Folie auf die Leiterschicht laminiert wurde. Damit kann ein aufwendiger Positionierprozess entfallen, da die zweite Folie (noch) keine Öffnungen hat, die mit der ersten Folie in Deckung zu bringen wären. Anschließend kann die zweite Folie im Bereich der ersten Öffnungen gelocht bzw. gestanzt werden. Die Position der zweiten Öffnung relativ zur ersten Öffnung in der ersten Folie spielt keine Rolle, solange sie innerhalb des oder in Überlappung mit dem Bereich der ersten Öffnung liegt und somit im Bereich, in dem später der Kontaktpin anliegt.

Die flexible Leiterplatte kann auf einfache Weise hergestellt werden, da die zweite Folie als Deckfolie zunächst ungelocht ist und somit vor dem Laminieren der Folien kein aufwendiger Ausrichtvorgang nötig ist.

Die Erfindung umfasst das Verfahren: Bereitstellen einer flexiblen Leiterplatte, so wie sie obenstehend und untenstehend beschrieben ist; Positionieren der flexiblen Leiterplatte mit der wenigstens einen ersten Öffnung auf wenigstens einem Kontaktpin, so dass die Leiterschicht den wenigstens einen Kontaktpin berührt; Anschweißen der Leiterschicht an den Kontaktpin durch die zweite Folie und/oder die zweite Öffnung hindurch (mittels Laserstrahlen), so dass beim Schweißen entstehende Dämpfe und/oder Wärme durch die zweite Öffnung entweichen können. Dabei entstehende Dämpfe und Gase führen in der Regel nicht zu einer Delamination zwischen der Leiterschicht und der zweiten Folie und auch nicht zu einer Schädigung der zweiten Folie, da diese Gase und Dämpfe und Wärme durch die zweite Öffnung nach außen entweichen können.

Gemäß einer Ausführungsform der Erfindung umfasst das Verfahren weiter ein Verschließen der zweiten Öffnung. Beispielsweise kann die zweite Öffnung nach dem Schweißen mit einem Verschluss aus Kunststoff verschlossen werden. Besteht beispielsweise die Gefahr von Korrosion der Schweißstelle durch Eindringen von Medium durch die zweite Öffnung, kann diese Öffnung nach dem Schweißen durch einen Tropfen oder eine Raupe eines Lackes, Globe-Tops, Klebers oder ähnlichem Material verschlossen werden (dies kann ein Werkstoff auf Epoxid- oder Acrylbasis sein, beispielsweise der gleiche Kleber, der zum Verbinden der Folien mit der Leiterschicht verwendet wurde).

### Kurze Beschreibung der Figuren

Im Folgenden werden Ausführungsbeispiele der Erfindung mit Bezug auf die beiliegenden Figuren detailliert beschrieben.
Fig. 1 zeigt einen schematischen Querschnitt durch eine flexible Leiterplatte.
Fig. 2 zeigt einen schematischen Querschnitt durch eine flexible Leiterplatte vor dem Kontaktieren eines Pins.
Fig. 3 zeigt einen schematischen Querschnitt durch die flexible Leiterplatte aus der Fig. 2 während eines Schweißvorgangs.
Fig. 4 zeigt einen schematischen Querschnitt durch die flexible Leiterplatte aus der Fig. 2 nach dem Schweißvorgang.

Grundsätzlich sind identische oder ähnliche Teile mit den gleichen Bezugszeichen versehen.

### Detaillierte Beschreibung von Ausführungsbeispielen

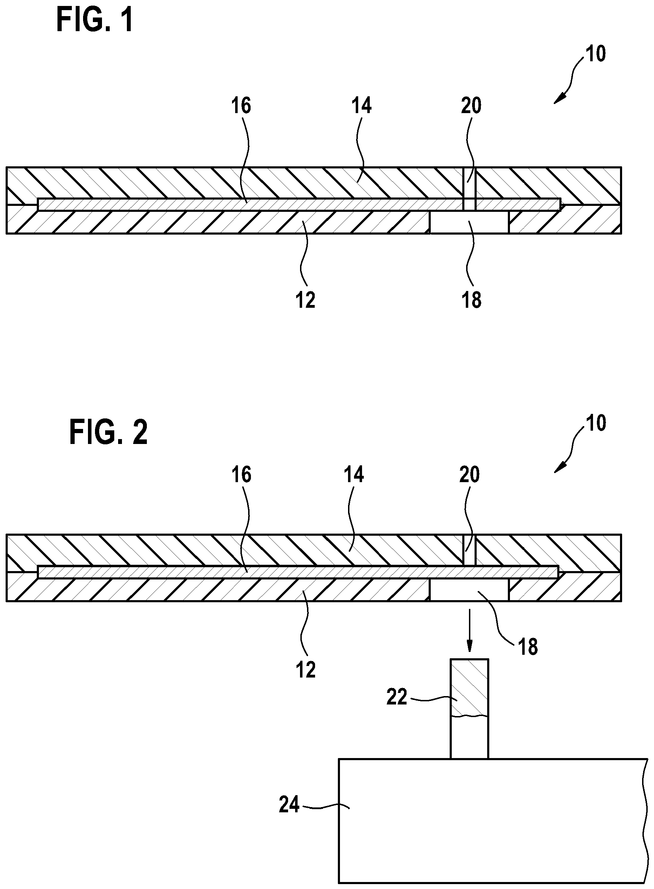

Fig. 1 zeigt eine flexible Leiterplatte 10, die aus einer ersten Folie 12 als Basisfolie, einer zweiten Folie 14 als Deckfolie und einer Leiterschicht 16 zwischen den beiden Folien 12, 14 aufgebaut ist. Die beiden Folien 12, 14 können beispielsweise aus Polyimid hergestellt sein und dünner als 0,1 mm sein. Die Leiterschicht 16 kann eine oder mehrere Leiterbahnen aus Kupfer umfassen und auch eine Dicke weniger als 0,1 mm aufweisen.

Zwischen den Folien 12, 14 und der Leiterschicht 16 können sich noch Schichten eines Klebers, beispielsweise auf Epoxid- oder Acrylbasis, befinden, mit dem die Folien 12, 14 auf die Leiterschicht 16 laminiert wurden.

Die erste Folie 12 weist eine Öffnung 18 auf, die dazu ausgeführt ist, einen Kontaktpin aufzunehmen, der mit der Leiterschicht 16 verbunden werden soll. Die Öffnung 18 kann beispielsweise zylinderförmig sein und beispielsweise durch Stanzen der ersten Folie 12 hergestellt worden sein. Insbesondere ist die erste Folie 12 bis zur Leiterschicht 16 komplett gelocht.

Die zweite Folie 14 weist auch eine Öffnung 20 auf, die der ersten Öffnung 18 gegenüberliegt. Auch die zweite Öffnung 20 kann zylinderförmig sein und durch Stanzen der zweiten Folie 14 hergestellt worden sein. Die Öffnung 20 weist einen (wesentlich) kleineren Durchmesser als die Öffnung 18 auf.

In Fig. 1 ist dargestellt, dass die beiden Öffnungen 18, 20 zentriert zueinander angeordnet sind. Es ist jedoch auch möglich, dass die Zentren der Öffnungen 18, 20 versetzt zueinander angeordnet sind und/oder dass die Öffnung 20 mit der Öffnung 18 lediglich teilweise überlappt.

Es ist zu verstehen, dass die Folien 12, 14 in der Regel nicht nur eine, sondern eine Mehrzahl von Öffnungen 18, 20 aufweisen werden. Da nur die erste Folie 12 Öffnungen 18 zur Aufnahme eines Kontaktpins aufweist, kann die Leiterbahn als einseitig geöffnet aufgefasst werden.

Die zweite Öffnung 20 kann beispielsweise durch Ausstanzen der zweiten Folie 14 erzeugt werden, nachdem die zweite Folie 14 auf die Leiterschicht 16 laminiert wurde. In diesem Fall kann die Öffnung 20 durch die Leiterschicht 16 hindurch bis zur ersten Öffnung 18 reichen.

Im Gegensatz dazu zeigt die Fig. 2, dass die Leiterschicht 16 zwischen den Öffnungen 18, 20 intakt ist. Dies kann beispielsweise dann der Fall sein, wenn die Öffnung 20 erzeugt wird, bevor die Folie 14 auf die Leiterschicht 16 laminiert wird.

Fig. 2 zeigt außerdem, wie die flexible Leiterplatte 10 auf einen Kontaktpin 22 aus Metall wie etwa Kupfer montiert wird. Der Kontaktpin 22 kann beispielsweise aus einer Elektronik 24 eines Steuergeräts herausragen. Die Öffnungl8 wird über den Kontaktpin 22 gestülpt, bis dieser die Leiterschicht 16 berührt.

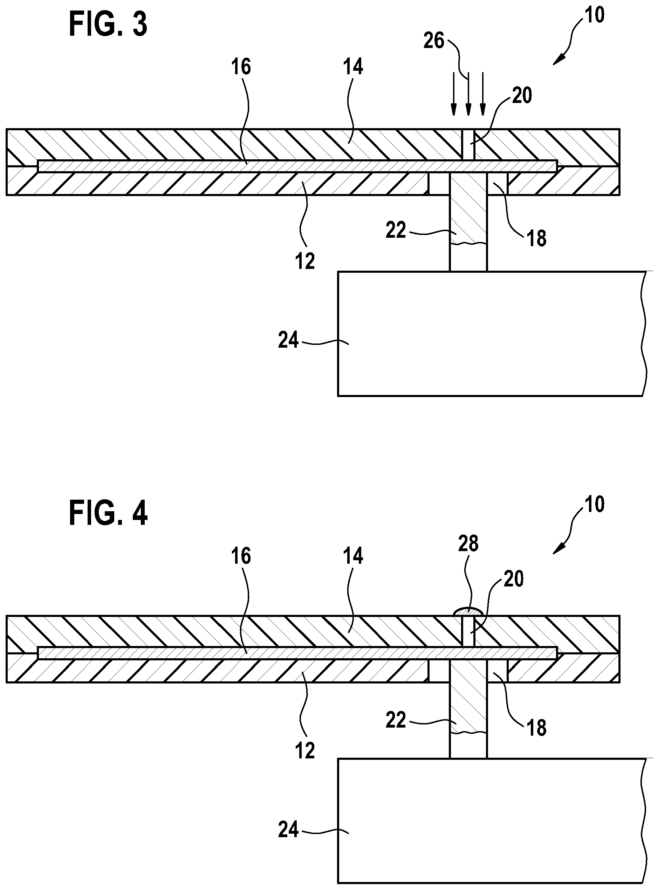

In der Fig. 3 wird dargestellt, wie der Kontaktpin 22 mit der flexiblen Leiterplatte 10 verschweißt wird. Laserlicht 26 wird durch die Öffnung 20 und die zweite Folie 14 auf die Leiterschicht 16 im Bereich der Öffnung 18 gestrahlt und die Leiterschicht 16 derart erhitzt, dass sie mit dem Kontaktpin 22 verschweißt wird. Dämpfe und Gase, die durch das Erhitzen der zweiten Folie 14 entstehen, können die flexible Leiterplatte 10 durch die Öffnung 20 verlassen. Auf diese Weise kann ein Ablösen der zweiten Folie 14 in der Regel verhindert werden.

Fig. 4 zeigt, dass die Öffnung 20 mit einem Verschluss 28 versiegelt werden kann, um die Leiterschicht 16 zu schützen. Nach dem Schweißen kann die Öffnung mit Lack, einem Globe-Top und/oder Kleber, beispielsweise auf Epoxid- oder Acrylbasis, verschlossen werden.

Ergänzend ist darauf hinzuweisen, dass "umfassend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Verfahren zum Herstellen einer Kontaktierung mit einer flexiblen Leiterplatte (10), das Verfahren umfassend:
Bereitstellen einer flexiblen Leiterplatte (10), umfassend:
eine erste Folie (12) mit wenigstens einer ersten Öffnung (18);
eine zweite Folie (14);
eine Leiterschicht (16) zwischen der ersten Folie (12) und der zweiten Folie (14), wobei durch die erste Öffnung (18) auf die Leiterschicht (16) zugegriffen werden kann;
wobei die zweite Folie (14) wenigstens eine zweite Öffnung (20) aufweist, die der wenigstens einen ersten Öffnung (18) zumindest teilweise gegenüberliegt und die einen kleineren Durchmesser als die wenigstens eine erste Öffnung (18) aufweist.
Positionieren der flexiblen Leiterplatte (10) mit der wenigstens einen ersten Öffnung (18) auf wenigstens einem Kontaktpin (22), so dass die Leiterschicht (16) den wenigstens einen Kontaktpin (22) berührt;
Anschweißen der Leiterschicht (16) an den Kontaktpin (22) durch die zweite Folie (14) und die zweite Öffnung (20) hindurch, so dass beim Schweißen entstehende Dämpfe und/oder Wärme durch die zweite Öffnung (20) entweichen können.

2. Verfahren nach Anspruch 1, weiter umfassend:
Verschließen der zweiten Öffnung (20).

3. Verfahren nach Anspruch 1,
wobei die erste Öffnung (18) die zweite Öffnung (20) vollständig überdeckt.

4. Verfahren nach Anspruch 1 oder 2,
wobei der Durchmesser der zweiten Öffnung (20) weniger als 20% des Durchmessers der ersten Öffnung (18) beträgt.

5. Verfahren nach einem der vorhergehenden Ansprüche,
wobei die erste Öffnung (18) und die zweite Öffnung (20) durch die Leiterschicht (16) vollständig voneinander abgetrennt sind.

6. Verfahren nach einem der vorhergehende Ansprüche,
wobei sich die zweite Öffnung (20) durch die Leiterschicht (16) bis zur ersten Öffnung (18) erstreckt.

## Claims

1. Method for establishing a contact-connection with a flexible printed circuit board (10), the method comprising:
providing a flexible printed circuit board (10), comprising:
a first film (12) with at least one first opening (18);
a second film (14);
a conductor layer (16) between the first film (12) and the second film (14), wherein the conductor layer (16) can be accessed through the first opening (18);
wherein the second film (14) has at least one second opening (20) which is at least partially situated opposite the at least one first opening (18) and which has a smaller diameter than the at least one first opening (18) ;
positioning the flexible printed circuit board (10) on at least one contact pin (22) by way of the at least one first opening (18), so that the conductor layer (16) touches the at least one contact pin (22);
welding the conductor layer (16) to the contact pin (22) through the second film (14) and the second opening (20), so that vapours and/or heat produced during welding can escape through the second opening (20).

2. Method according to Claim 1, further comprising:
closing the second opening (20).

3. Method according to Claim 1,
wherein the first opening (18) completely covers the second opening (20).

4. Method according to Claim 1 or 2,
wherein the diameter of the second opening (20) is less than 20% of the diameter of the first opening (18).

5. Method according to one of the preceding claims,
wherein the first opening (18) and the second opening (20) are completely separated from one another by the conductor layer (16).

6. Method according to one of the preceding claims,
wherein the second opening (20) extends through the conductor layer (16) as far as the first opening (18).

## Revendications

1. Procédé de mise en contact avec une carte de circuits imprimés souple (10), le procédé comprenant les étapes consistant à :
fournir une carte de circuits imprimés souple (10), comprenant :
un premier film (12) doté d'au moins une ouverture (18) ;
un deuxième film (14) ;
une couche conductrice (16) entre le premier film (12) et le deuxième film (14), la couche conductrice (16) étant accessible à travers la première ouverture (18) ;
le deuxième film (14) présentant au moins une deuxième ouverture (20) qui est opposée au moins en partie à ladite au moins une première ouverture (14), et qui présente un diamètre inférieur à celui de ladite au moins une première ouverture (18),
positionner la carte de circuits imprimés souple (10) avec ladite au moins une première ouverture (18) sur au moins une broche de contact (22) de sorte que la couche conductrice (16) touche ladite au moins une broche de contact (22) ;
souder la couche conductrice (16) à la broche de contact (22) à travers le deuxième film (14) et la deuxième ouverture (20) de sorte que des vapeurs et/ou de la chaleur créées lors du soudage puissent s'échapper à travers la deuxième ouverture (20).

2. Procédé selon la revendication 1, comprenant en outre :
la fermeture de la deuxième ouverture (20).

3. Procédé selon la revendication 1, dans lequel la première ouverture (18) recouvre complètement la deuxième ouverture (20).

4. Procédé selon la revendication 1 ou 2, dans lequel le diamètre de la deuxième ouverture (20) est inférieur à 20 % du diamètre de la première ouverture (18).

5. Procédé selon l'une quelconque des revendications précédentes, dans lequel la première ouverture (18) et la deuxième ouverture (20) sont complètement séparées l'une de l'autre par la couche conductrice (16).

6. Procédé selon l'une quelconque des revendications précédentes, dans lequel la deuxième ouverture (20) s'étend à travers la couche conductrice (16) jusqu'à la première ouverture (18).
